# FASCICULE DE BREVET EUROPEEN

(11) **EP 0 913 931 B1**
(45) Date de publication et mention de la délivrance du brevet: **14.05.2003**
(21) Numéro de dépôt: 98203536.2
(22) Date de dépôt: 20.10.1998
(51) Int. Cl.: H03F 3/45

(54) **Amplificateur à fort gain ayant une dynamique de sortie limitée**
Verstärker mit hohem Verstärkungsgrad und begrenzter Ausgangsdynamik
High gain amplifier with limited output dynamic

(30) Priorité: 28.10.1997 FR 9713509
(43) Date de publication de la demande: 06.05.1999
(73) Titulaire: Koninklijke Philips Electronics N.V., 5621 BA Eindhoven (NL)
(72) Inventeur: Ridgers, Timothy, 75008 Paris (FR)
(74) Mandataire: Charpail, François

(56) Documents cités:
- US-A- 4 929 910
- US-A- 5 345 346
- US-A- 5 493 254
- STETZLER T D ET AL: "A 2.7-4.5 V SINGLE CHIP GSM TRANSCEIVER RF INTEGRATED CIRCUIT" IEEE JOURNAL OF SOLID-STATE CIRCUITS, vol. 30, no. 12, 1 décembre 1995, pages 1421-1428, XP000557247

## Description

La présente invention concerne un amplificateur tel que défini dans le préambule de la revendication 1. Un tel amplificateur est connu du document US-A-4 929 910.

Un amplificateur différentiel, est d'usage courant dans l'industrie des circuits intégrés. Il est notamment décrit dans l'ouvrage "Analysis and Design of Analog Integrated circuits", de Mm. Gray et Meyer. Le gain et l'amplitude maximale de la tension de sortie de cet amplificateur différentiel sont tous deux proportionnels au produit entre la valeur de l'impédance des branches résistives et la valeur du courant débité par la source de courant, appelé courant de polarisation. Dans certaines applications, particulièrement des applications de réception ou de traitement de signaux radio-électriques, dans lesquelles la réduction de toute forme de bruit pouvant affecter les signaux traités est une priorité essentielle, cet amplificateur a pour fonction de réaliser simultanément une amplification d'une tension d'entrée de forme sinusoïdale et sa transformation en une tension de sortie de forme carrée. Une telle transformation permet d'éviter que l'amplification n'introduise dans la tension de sortie une composante de bruit supplémentaire, liée à la valeur instantanée de la tension d'entrée. Néanmoins, cette transformation nécessite un fort gain afin que la tension de sortie présente des fronts d'une raideur telle que les transitions qu'ils représentent soient bien définies dans le temps. Ceci peut être obtenu en choisissant une forte valeur pour l'impédance de la branche résistive. Une telle solution présente toutefois un inconvénient majeur : elle a pour effet d'augmenter considérablement la valeur de l'amplitude maximale de la tension de sortie, ce qui peut provoquer la saturation de circuits destinés à recevoir ladite tension, et donc perturber considérablement le fonctionnement du système intégrant l'amplificateur, ce qui n'est pas acceptable.

La présente invention a pour but de remédier dans une large mesure à cet inconvénient, en proposant un amplificateur dont le gain et la valeur maximale de l'amplitude de la tension de sortie peuvent être réglés indépendamment l'un de l'autre.

En effet, un amplificateur conforme au paragraphe introductif se caractérise selon l'invention en ce que chaque branche résistive est munie d'un premier élément permettant la conduction d'un courant, contrôlée par le potentiel de sa prise intermédiaire, vers son transistor associé lorsque celui-ci est conducteur.

Dans un tel amplificateur, le choix d'une forte valeur de résistance pour le premier élément résistif résultera en un fort gain permettant d'obtenir une bonne transformation d'une tension d'entrée sinusoïdale en une tension de sortie carrée, tandis qu'un choix judicieux de la valeur de résistance du deuxième élément résistif permettra de limiter l'amplitude maximale de la tension de sortie à une valeur telle que ladite tension ne pourra pas provoquer la saturation des circuits destinés à la recevoir.

Dans un de ses modes de réalisation, avantageux par la simplicité de sa structure et l'économie de composants qui en résulte, un amplificateur selon l'invention est caractérisé par la revendication 2.

Les revendications 3 et 4 présentent des modes de réalisation particuliers d'un amplificateur selon l'invention.

Ainsi qu'exposé plus haut, un amplificateur tel que décrit plus haut peut être avantageusement mis en oeuvre pour le traitement de signaux radio-électriques. L'invention concerne donc également un appareil de radio-téléphonie conforme à la revendication 5.

L'invention sera mieux comprise à l'aide de la description suivante de quelques modes de réalisation, faite à titre d'exemple non-limitatif et en regard des dessins annexés, dans lesquels :
- la figure 1 est un schéma électrique décrivant un amplificateur différentiel connu,
- la figure 2 est un schéma électrique décrivant un amplificateur conforme à un mode de réalisation avantageux de l'invention, et
- la figure 3 est un schéma fonctionnel décrivant un appareil de radio-téléphonie mettant en oeuvre un amplificateur conforme à l'invention.

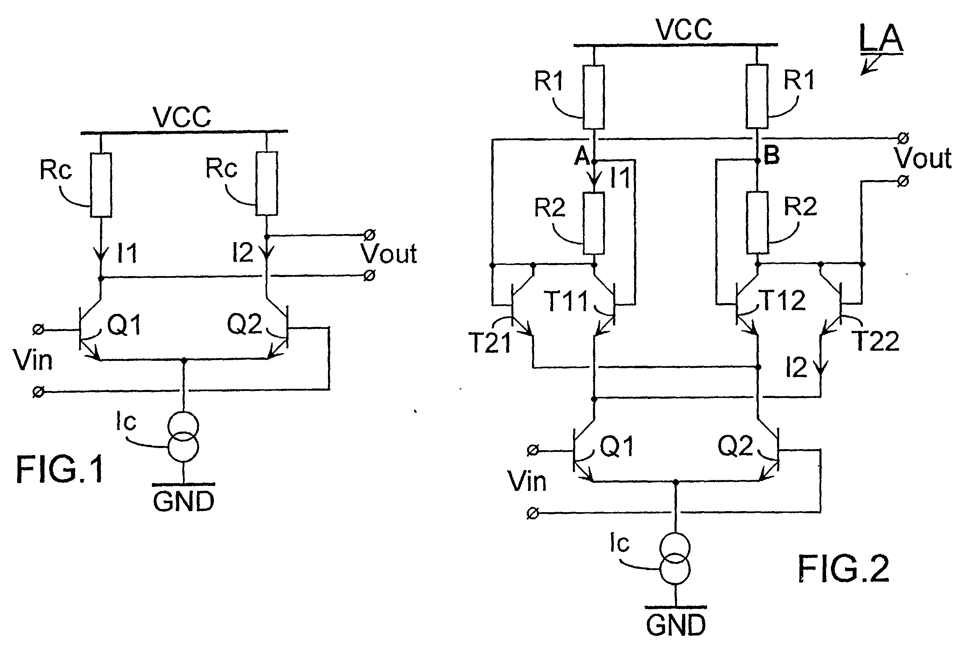

La figure 1 représente un amplificateur différentiel connu. Cet amplificateur comprend un premier et un deuxième transistors, Q1 et Q2, montés en paire différentielle. Les transistors Q1 et Q2 sont, dans cet exemple, des transistors bipolaires. Chaque transistor, Q1 ou Q2, présente une borne de polarisation, constituée par sa base, une borne de référence, constituée par son émetteur, reliée à une source de courant débitant un courant de polarisation Ic, et une borne de transfert, constituée par son collecteur, reliée à une borne d'alimentation VCC via une branche résistive constituée par une résistance de charge Rc. Les bornes de polarisation et les bornes de transfert des premier et deuxième transistors Q1 et Q2 forment respectivement une entrée et une sortie différentielles, lesquelles sont respectivement destinées à recevoir et à délivrer une tension d'entrée Vin et une tension de sortie Vout, un rapport Vout/Vin entre les valeurs desdites tensions définissant le gain G de l'amplificateur.

Il est connu qu'autour de l'équilibre, en considérant, en première approximation, que les éléments constituant l'amplificateur différentiel sont parfaits, le gain G de l'amplificateur s'exprime sous la forme G=q.Rc.Ic/(2.k.T), où q est la charge de l'électron, k la constante de Boltzmann et T la température absolue. On sait par ailleurs que l'amplitude maximale de la tension de sortie Voutₘₐₓ s'écrit Voutₘₐₓ=Rc.Ic. Il apparaît ainsi que le gain G de l'amplificateur et l'amplitude maximale de sa tension de sortie Voutₘₐₓ sont tous deux proportionnels au produit entre la résistance Rc et le courant de polarisation Ic. Lorsque l'on souhaite réaliser une fonction de transformation d'une tension d'entrée Vin de forme sinusoïdale en une tension de sortie Vout de forme carrée, la valeur du gain G de l'amplificateur doit être grande, c'est-à-dire que la valeur du produit Rc.Ic doit être grande. Afin de ne pas provoquer de consommation excessive de courant, on choisit généralement d'augmenter la valeur de la résistance de charge Rc plutôt que celle du courant de polarisation Ic. Quoi qu'il en soit, l'augmentation de la valeur du produit Rc.Ic permet d'obtenir un fort gain G, mais provoque l'augmentation de la valeur de l'amplitude maximale de la tension de sortie Voutₘₐₓ. Or la tension de sortie Vout est, le plus souvent, destinée à être utilisée par un ou plusieurs circuits qui sont disposés en aval de l'amplificateur. Ces circuits présentent une admissibilité, c'est-à-dire une valeur maximale de leur tension d'entrée, bien définie. Cela signifie que si la tension d'entrée d'un de ces circuits dépasse cette valeur maximale, les éléments qui le constituent vont entrer dans un régime de saturation et ainsi provoquer des déformations des signaux qu'ils doivent traiter. Une augmentation du gain G opérée selon la méthode décrite ci-dessus risque de rendre l'amplitude maximale de la tension de sortie Voutₘₐₓ supérieure à ladite admissibilité, ce qui perturbera le fonctionnement de l'ensemble du système intégrant l'amplificateur. Ainsi, si l'amplitude maximale de la tension de sortie Voutₘₐₓ est fixée à 150 Millivolts, ce qui est une valeur courante pour certaines des technologies bipolaires actuelles, le gain G de l'amplificateur devra nécessairement être limité à 2,9, ce qui constitue une valeur insuffisante pour réaliser correctement la fonction de transformation recherchée.

La figure 2 représente un amplificateur LA conforme à l'invention. Dans la mesure du possible, les éléments communs à cet amplificateur et à l'amplificateur différentiel décrit ci-dessus ont été affectés des mêmes références, afin de faciliter la compréhension de l'exposé. Dans cet amplificateur LA, les branches résistives des premier et deuxième transistors Q1 et Q2 sont constituées chacune d'une première et d'une deuxième résistances R1 et R2 disposées en série. Ces branches résistives présentent donc respectivement une première et une deuxième prises A et B, intermédiaires aux première et deuxième résistances R1 et R2. L'amplificateur LA comporte en outre :
. un troisième transistor T11 dont le trajet de courant principal est inséré entre le premier transistor Q1 et sa branche résistive associée, et un quatrième transistor T12 dont le trajet de courant principal est inséré entre le deuxième transistor Q2 et sa branche résistive associée, les bornes de polarisation des troisième et quatrième transistors T11 et T12 étant respectivement reliées aux première et deuxième prises intermédiaires A et B, et
. une première diode T21 disposée en direct entre les bornes de transfert des troisième et deuxième transistors T11 et Q2, et une deuxième diode T22 disposée en direct entre les bornes de transfert des quatrième et premier transistors T12 et Q1.

Dans l'exemple décrit ici, chacune des première et deuxième diodes T21 et T22 est constituée par un transistor dont la borne de polarisation est connectée à sa borné de transfert.

Par transposition de l'équation du gain de l'amplificateur différentiel, le gain G de cet amplificateur LA peut être exprimé sous la forme G=q.Ic.(R1+R2)/2.k.T, la branche résistive Rc étant constituée par le montage en série des première et deuxième résistances R1 et R2. En situation de fort déséquilibre, c'est-à-dire lorsque la valeur absolue de la tension d'entrée Vin est grande, un seul des premier et deuxième transistors Q1 et Q2 de la paire différentielle conduit. Si l'on suppose, par exemple, que la tension d'entrée Vin est positive, c'est le premier transistor Q1 qui conduit un courant, dont une partie I1 passe à travers le troisième transistor T11 et sa branche résistive R1, R2, et dont une autre partie I2 passe au travers de la branche résistive R1, R2 du quatrième transistor T12, puis au travers de la deuxième diode T22. On peut donc écrire : I1.R1+Vbe(T11)=I2.(R1+R2)+Vbe(T22), où Vbe(Tii) représente la tension base-émetteur du transistor Tii. On constate l'apparition d'une dissymétrie dans les valeurs des courants I1 et I2, le courant I1 traversant le troisième transistor T11 étant supérieur au courant I2 traversant la diode T22, du fait que le potentiel de la borne de polarisation du troisième transistor T11 est supérieur à celui de la borne de polarisation du transistor constituant la diode T22. Les effets de cette dissymétrie sur les tensions base-émetteur peuvent toutefois être négligés, car les tensions base-émetteur sont faibles devant les chutes de tension générées dans les branches résistives. On peut ainsi écrire, en première approximation, que I1.R1=I2.(R1+R2). Sachant d'autre part que I1+I2=Ic dans la présente hypothèse, selon laquelle seul le premier transistor Q1 conduit, on obtient I1=Ic.(R1+R2)/(2.R1+R2) et I2=Ic.R1/(2.R1+R2). L'amplitude maximale de la tension de sortie est ici Voutₘₐₓ = (R1+R2)(I1-I2), ce qui s'écrit encore : Voutₘₐₓ=Ic.R2.(R1+R2)/(2.R1+R2). Il apparaît donc que le gain G de l'amplificateur et l'amplitude maximale de la tension de sortie Voutₘₐₓ évoluent différemment en fonction des valeurs nominales des première et deuxième résistances R1 et R2. Si la valeur nominale de la première résistance R1 est choisie grande devant celle de la deuxième résistance R2, la valeur du gain G sera essentiellement déterminée par la valeur nominale de la première résistance R1, tandis que la valeur de l'amplitude maximale de la tension de sortie Voutₘₐₓ sera essentiellement déterminée par la valeur nominale de la deuxième résistance R2.

Un exemple numérique permettra de mieux apprécier les avantages d'un tel amplificateur : si la valeur du courant de polarisation Ic est de 100 Micro-ampères, ce qui constitue une valeur courante dans les technologies utilisées à l'heure actuelle, et si l'on choisit R1=7,5 KiloOhms et R2=2,5 KiloOhms, et avec k.T/q=26 Millivolts à 300K, on obtient, selon les équations précédentes, une amplitude maximale de la tension de sortie Voutₘₐₓ de l'ordre de 140 Millivolts pour un gain G voisin de 19, ce qui est tout-à-fait convenable pour réaliser la fonction de transformation recherchée, tout en prévenant tout risque de saturation pour les circuits disposés en aval de l'amplificateur. Une valeur de gain aussi importante résulterait, dans l'amplificateur différentiel connu, en une amplitude maximale de la tension de sortie de l'ordre de 1 Volt, ce qui illustre bien l'ampleur de la limitation obtenue sur la tension de sortie grâce à l'invention.

Si, dans le mode de réalisation décrit par la figure 2, les transistors sont des transistors de type bipolaire, il est tout-à-fait envisageable de leur substituer des transistors de type MOS dont les grilles, les drains et les sources constitueraient respectivement des bornes de polarisation, de transfert et de référence. Par ailleurs, des moyens autres que l'assemblage des transistors T11, T12 et des diodes T21, T22 décrit par la figure 2 peuvent être utilisés pour réaliser la conduction d'un courant, contrôlée par la prise intermédiaire A ou B d'une branche résistive, vers son transistor associé Q1 ou Q2 lorsque celui-ci est conducteur, et la conduction d'un courant vers l'autre transistor Q2 ou Q1 de la paire différentielle lorsque celui-ci est conducteur. Ces moyens sont connus de l'homme du métier et ne sortent pas du cadre de l'invention.

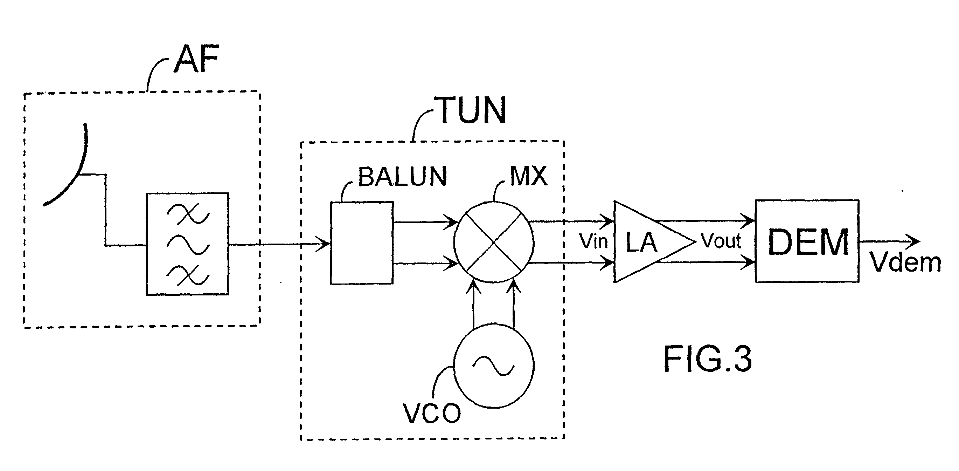

La figure 3 représente partiellement un appareil de radio-téléphonie mettant en oeuvre un amplificateur selon l'invention. Cet appareil comporte :
. un système d'antenne et de filtrage AF permettant la réception d'un signal radio-électrique modulé en fréquence,
. un module de sélection TUN comprenant un symétriseur BALUN destiné à transformer un signal asymétrique en provenance du système d'antenne et de filtrage AF en un signal symétrique, un oscillateur VCO et un mélangeur MX, ledit module de sélection TUN permettant la sélection du signal radio-électrique, et étant destiné à délivrer un signal de sortie représentatif dudit signal radio-électrique, dont la fréquence a été convertie vers une fréquence intermédiaire,
. un démodulateur DEM destiné à restituer un signal audio démodulé Vdem sur la base du signal de sortie du module de sélection TUN, et
. un amplificateur LA tel que décrit plus haut, inséré en amont du démodulateur DEM.

Ainsi que démontré précédemment, l'amplificateur LA peut présenter un gain important tout en ayant une amplitude maximale de sa tension de sortie Vout suffisamment faible pour ne pas saturer l'étage d'entrée du démodulateur DEM. L'amplificateur LA peut donc effectuer simultanément une amplification de sa tension d'entrée Vin et une transformation de cette tension Vin, qui est de forme sinusoïdale, en une tension de sortie Vout de forme carrée. Cette transformation permet d'éviter que l'amplification n'introduise dans la tension de sortie Vout une composante de bruit supplémentaire, liée à la valeur instantanée du signal modulé.

## Revendications

1. Amplificateur comprenant un premier et un deuxième transistors montés en paire différentielle, chaque transistor présentant une borne de polarisation, une borne de référence reliée à une source de courant et une borne de transfert reliée à une borne d'alimentation via une branche résistive, les bornes de polarisation et les bornes de transfert des premier et deuxième transistors formant respectivement une entrée et une sortie différentielles, lesquelles sont respectivement destinées à recevoir et à délivrer une tension d'entrée et une tension de sortie, un rapport entre les valeurs des composantes alternatives desdites tensions définissant le gain de l'amplificateur, les branches résistives des premier et deuxième transistors étant munies chacune d'au moins une prise intermédiaire entre un premier et un deuxième éléments résistifs disposés en série, chaque branche résistive étant munie d'un deuxième élément permettant la conduction d'un courant vers l'autre transistor de la paire différentielle lorsque celui-ci est conducteur, lequel amplificeteur est **caractérisé en ce que** chaque branche résistive est munie d'un premier élément permettant la conduction d'un courant, contrôlée par le potentiel de sa prise intermédiaire, vers son transistor associé lorsque celui-ci est conducteur.

2. Amplificateur selon la revendication 1, **caractérisé en ce qu'**il comporte :
. un troisième et un quatrième transistors dont les trajets de courant principaux sont respectivement insérés entre le premier transistor et sa branche résistive associée, et entre le deuxième transistor et sa branche résistive associée, les bornes de polarisation des troisième et quatrième transistors étant respectivement reliées aux première et deuxième prises intermédiaires, et
. une première et une deuxième diodes disposées en direct respectivement entre les bornes de transfert des troisième et deuxième transistors, et entre les bornes de transfert des quatrième et premier transistors.

3. Amplificateur selon la revendication 1, **caractérisé en ce que**, dans chaque branche résistive, l'élément résistif qui est relié à la borne d'alimentation présente une valeur de résistance plus élevée que l'autre.

4. Amplificateur selon la revendication 2, **caractérisé en ce que** chacune des première et deuxième diodes est constituée par un transistor dont la borne de polarisation est connectée à sa borne de transfert.

5. Appareil de radio-téléphonie, comportant :
. un système d'antenne et de filtrage permettant la réception d'un signal radio-électrique modulé en fréquence,
. un module de sélection composé d'au moins un oscillateur et un mélangeur, permettant la sélection dudit signal radio-électrique, et destiné à délivrer un signal de sortie représentatif dudit signal radio-électrique, dont la fréquence a été convertie vers une fréquence intermédiaire,
. un démodulateur destiné à restituer un signal audio démodulé sur la base du signal de sortie du module de sélection,
appareil **caractérisé en ce qu'**il comporte un amplificateur conforme à la revendication 1, inséré en amont du démodulateur.

## Patentansprüche

1. Verstärker mit einem ersten und einem zweiten, als Differenzialpaar geschalteten Transistor, wobei jeder Transistor eine Polarisationsklemme, eine mit einer Stromquelle verbundene Bezugsklemme und eine mit einer Versorgungsklemme über einen resistiven Zweig verbundene Übertragungsklemme aufweist, die Polarisationsklemmen und die Übertragungsklemmen des ersten und zweiten Transistors respektive einen differenzialen Eingang und Ausgang bilden, die respektive dazu bestimmt sind, eine Eingangsspannung und eine Ausgangsspannung zu erhalten bzw. abzugeben, das Verhältnis zwischen den Werten der wechselseitigen Komponenten der besagten Spannungen den Verstärkungsgrad des Verstärkers definieren, die resistiven Zweige des ersten und zweiten Transistors jeweils mit mindestens einer Zwischenversorgung zwischen einem ersten und einem zweiten, in Serie angeordneten Element versehen sind, jeder resistive Zweig mit einem zweiten Element versehen ist, das die Leitung eines Stroms zum anderen Transistor des Differenzialpaars ermöglicht, wenn dieses leitend ist, wobei der Verstärker **dadurch gekennzeichnet ist, dass** jeder resistive Zweig mit einem ersten Element versehen ist, das die Leitung eines Stroms ermöglicht, gesteuert vom Potenzial seiner Zwischenversorgung, an seinen angegliederten Transistor, wenn dieser leitend ist.

2. Verstärker nach Anspruch 1, **dadurch gekennzeichnet, dass** er enthält:
. einen dritten und einen vierten Transistor, deren Hauptstromwege respektive zwischen dem ersten Transistor und seinem angegliederten resistiven Zweig und zwischen dem zweiten Transistor und seinem angegliederten resistiven Zweig eingefügt sind, wobei die Polarisationsklemmen des dritten und vierten Transistors respektive mit der ersten und zweiten Zwischenversorgung verbunden sind, und
. einer ersten und einer zweiten Diode, respektive direkt zwischen den Übertragungsklemmen des dritten und zweiten Transistors und zwischen den Übertragungsklemmen des vierten und ersten Transistors angeordnet.

3. Verstärker nach Anspruch 1, **dadurch gekennzeichnet, dass** in jedem resistiven Zweig das resistive Element, das mit der Versorgungsklemme verbunden ist, einen höheren Widerstandswert aufweist als das andere.

4. Verstärker nach Anspruch 2, **dadurch gekennzeichnet, dass** jede der ersten und zweiten Dioden von einem Transistor gebildet wird, dessen Polarisationsklemme mit seiner Übertragungsklemme verbunden ist.

5. Funktelefongerät mit:
. einem Antennen- und Filtersystem, um den Empfang eines frequenzmodulierten Funksignals zu ermöglichen,
. einem Auswahlmodul bestehend aus mindestens einem Oszillator und einem Mischer, der die Auswahl des besagten Funksignals ermöglicht und vorgesehen ist, um ein repräsentatives Ausgangssignal des besagten Funksignals zu liefern, dessen Frequenz in eine Zwischenfrequenz gewandelt wurde,
. einem Demodulator zur Wiederherstellung eines demodulierten Audiosignals auf der Basis des Ausgangssignals des Auswahlmoduls,
**dadurch gekennzeichnetes** Gerät, dass es einen dem Anspruch 1 entsprechenden Verstärker aufweist, der vor den Demodulator geschaltet wird.

## Claims

1. An amplifier comprising a first and a second transistor arranged as a differential pair, each transistor having a bias terminal, a reference terminal connected to a current source and a transfer terminal connected to a supply terminal via a resistive branch, the bias terminals and the transfer terminals of the first and second transistors forming, respectively, a differential input and output, which are intended to receive and supply an input voltage and an output voltage respectively, a ratio between the values of the AC components of said voltages defining the gain of the amplifier, the resistive branches of the first and second transistors having each at least one intermediate terminal between a first and a second resistive element arranged in series, each resistive branch being provided with a second element which permits the conduction of a current to the other transistor of the differential pair when said other transistor is conductive, which amplifier is **characterized in that** each resistor branch comprises a first element which permits the conduction of a current controlled by the potential of its intermediate terminal to its associated transistor when the latter is conductive.

2. An amplifier as claimed in claim 1, **characterized in that** it comprises:
a third and a fourth transistor whose main current paths are inserted between the first transistor and its associated resistive branch and between the second transistor and its associated resistive branch respectively, the bias terminals of the third and the fourth transistor being respectively connected to the first and the second intermediate terminal, and
a first and a second diode arranged in forward direction between the transfer terminals of the third and the second transistor, and between the transfer terminals of the fourth and the first transistor, respectively.

3. An amplifier as claimed in claim 1, **characterized in that** in each resistive branch, the resistive element which is connected to the supply terminal has a higher resistance value than the other one.

4. An amplifier as claimed in claim 2, **characterized in that** each of the first and second diodes is formed by a transistor whose bias terminal is connected to its transfer terminal.

5. A radio telephony device, comprising:
an antenna and filter system which enables to receive a frequency-modulated radio signal,
a selection module comprising at least an oscillator and a mixer, which selection module permits the selection of said radio signal and is intended to deliver an output signal that represents said radio signal, and whose frequency has been converted to an intermediate frequency,
a demodulator intended to restore a demodulated audio signal on the basis of the output signal of the selection module,
which device is **characterized in that** it comprises an amplifier as claimed in claim 1 inserted upstream of the demodulator.
